# EUROPEAN PATENT SPECIFICATION

(11) **EP 3 477 797 B1**
(45) Date of publication and mention of the grant of the patent: **04.05.2022**
(21) Application number: 18201949.7
(22) Date of filing: 23.10.2018
(51) Int. Cl.: H01R 43/20

(54) **ASSEMBLY SYSTEM**
MONTAGESYSTEM
SYSTÈME D'ASSEMBLAGE

(30) Priority: 25.10.2017 CN 201711007567
(43) Date of publication of application: 01.05.2019
(73) Proprietor: Tyco Electronics (Shanghai) Co., Ltd., China (Shanghai) Pilot Free Trade Zone Shanghai (CN); TE Connectivity Corporation, Berwyn, PA 19312 (US); Kunshan League Automechanism Co., Ltd., Kunshan City Jiangsu (CN); Tyco Electronics Polska Sp. z.o.o., 02-677 Warsaw (PL)
(72) Inventor: DENG, Yingcong, Shanghai 200233 (CN); KOWALSKI, Jaroslaw, 85-059 Bydgoszcz (PL); PRZYBYLSKI, Andrzej, 85-059 Bydgoszcz (PL); GRZEBSKI, Jaroslaw, 85-059 Bydgoszcz (PL); ZHANG, Dandan, Shanghai 200233 (CN); HU, Lvhai, Shanghai 200233 (CN); XIE, Fengchun, Shanghai 200233 (CN); LIU, Yun, Shanghai 200233 (CN); LU, Roberto Francisco-Yi, Bellevue, WA 98006 (US); WU, Haidong, Kunshan City, Jiangsu (CN); XIAO, Hui, Kunshan City, Jiangsu (CN)
(74) Representative: Grünecker Patent- und Rechtsanwälte PartG mbB

(56) References cited:
- WO-A1-2015/173760
- CN-A- 106 129 775
- CN-A- 106 785 794
- JP-A- 2005 026 073
- JP-A- 2008 166 224
- US-A- 4 967 470
- US-A1- 2016 064 888

## Description

### BACKGROUND OF THE INVENTION

### Field of the Invention

The present disclosure relates to an assembly system for inserting contact into a housing.

### Description of the Related Art

In the field of connector manufacturing, it often needs to insert metal contacts into an insulation housing. In the art, the insertion of metal contacts is usually performed by manual. During inserting the metal contacts, an operator needs to grasp the metal contact by hand and force it into a contact installation slot of the insulation housing. However, during insertion, the hand of the operator is prone to shake, which will bend the metal contact, resulting in deformation or damage of the metal contact, reducing the quality of the product. In addition, operation of inserting the metal contact by manual is very low in efficiency.

WO 2015/173760 A1 discloses an automatic distributing system for placing components of electrical connectors on a tray with the help of a robot guided by a visual sensor. With this system, the components (e.g. contacts, cases and insulation blocks) can be assorted on the tray, but still need to be assembled in a subsequent process step.

In JP 2008 166224 A, an assembly system, according to the preamble of claim 1, capable of simultaneously inserting multiple rod-shaped terminal fittings made of bent sheet metal into a plurality of connector housings is disclosed. This system is limited, since in each connector housing, only one terminal fitting is inserted into one terminal accommodating chamber at a time.

### SUMMARY OF THE INVENTION

The present disclosure has been made to overcome or alleviate at least one aspect of the above mentioned disadvantages.

According to the present invention, an assembly system according to claim 1 is provided, comprising: a fixing device configured to fix a housing; and a pressing mechanism adapted to assemble a contact into the housing. The pressing mechanism comprises: a fixing block formed with a contact guiding slot adapted to receive the contact therein; and a movable block movably mounted on the fixing block and adapted to press the contact downward, the movable block is moved downward to press the contact received in the contact guiding slot into a contact installation slot of the housing in a condition where the contact guiding slot of the fixing block is aligned to the contact installation slot of the housing.

According to an exemplary embodiment of the present disclosure, the assembly system further comprises a rotatable table configured to be rotated about a vertical axis. The fixing device is mounted on the rotatable table, and the rotatable table is adapted to rotate the fixing device to a contact assembly station where the contact installation slot of the housing fixed on the fixing device is aligned to the contact guiding slot of the fixing block on the pressing mechanism.

According to another exemplary embodiment of the present disclosure, a plurality of fixing devices are mounted on the rotatable table around the periphery of rotatable table and separated from each other. The rotatable table is adapted to rotate the plurality of fixing devices to the contact assembly station one by one.

According to another exemplary embodiment of the present disclosure, the pressing mechanism further comprises a driving device configured to drive the movable block to move downward.

According to another exemplary embodiment of the present disclosure, the driving device comprises a motor, an air cylinder or a hydraulic cylinder.

According to another exemplary embodiment of the present disclosure, a plurality of contact guiding slots are formed in the fixing block, and a plurality of contact installation slots are formed in the housing. The pressing mechanism is adapted to press a plurality of contacts received in the plurality of contact guiding slots, respectively, into the plurality of contact installation slots at one time.

According to another exemplary embodiment of the present disclosure, the assembly system further comprises a robot adapted to grip the contact and insert the gripped contact into the contact guiding slot of the fixing block.

According to another exemplary embodiment of the present disclosure, the assembly system further comprises a contact supply mechanism configured to supply the contact to be assembled.

According to another exemplary embodiment of the present disclosure, the assembly system further comprises a contact positioning mechanism formed with a contact positioning slot in which the contact is adapted to be positioned.

According to another exemplary embodiment of the present disclosure, the contact supply mechanism comprises a linear vibration guide extending in a first horizontal direction, and the contacts to be assembled are loaded in the linear vibration guide. The contact positioning slot of the contact positioning mechanism is located at one end of the linear vibration guide and aligned to the linear vibration guide; and the linear vibration guide is adapted to drive the contacts by vibration, so as to move the contacts toward the contact positioning slot of the contact positioning mechanism.

According to another exemplary embodiment of the present disclosure, the contact positioning mechanism is configured to be movable in a second horizontal direction perpendicular to the first horizontal direction; and the contact positioning mechanism is moved in the second horizontal direction and separated from the linear vibration guide after the contact is moved from the linear vibration guide into the contact positioning slot.

According to another exemplary embodiment of the present disclosure, the assembly system further comprises a contactless sensor configured to detect whether the contact in the contact positioning mechanism is qualified.

According to another exemplary embodiment of the present disclosure, the contactless sensor comprises a distance sensor, a visual sensor or an infrared sensor.

According to another exemplary embodiment of the present disclosure, the contactless sensor is fixed to the contact positioning mechanism and moved together with the contact positioning mechanism in the second horizontal direction.

According to another exemplary embodiment of the present disclosure, the contact positioning slot of the contact positioning mechanism is adapted to position the contact in a horizontal posture.

According to another exemplary embodiment of the present disclosure, the robot comprises a manipulator adapted to grip the contact positioned in the horizontal posture from the contact positioning mechanism.

According to another exemplary embodiment of the present disclosure, the robot further comprises a rotation mechanism adapted to rotate the manipulator, so as to rotate the contact from the horizontal posture to a vertical posture.

According to another exemplary embodiment of the present disclosure, the robot is adapted to insert the gripped contact in the vertical posture into the contact guiding slot of the pressing mechanism.

According to another non-claimed aspect of the present disclosure, there is provided a method of assembling a contact into a housing, comprising steps of:
S100: providing the assembly system as mentioned in the above embodiment;
S200: synchronously performing the following steps S210 and S220, wherein
   the step S210 comprises steps of:
      S211: supplying the contact to the contact positioning mechanism (400) by the contact supply mechanism;
      S212: moving the contact positioning mechanism to separate it from the contact supply mechanism;
      S213: detecting whether the contact in the contact positioning mechanism is qualified by the contactless sensor;
      S214: gripping the contact in the horizontal posture from the contact positioning mechanism by the robot;
      S215: rotating the gripped contact from the horizontal posture to the vertical posture by the robot; and
      S216: inserting the gripped contact in the vertical posture into the contact guiding slot of the pressing mechanism by the robot, and
   the step S220 comprises steps of:
      S221: mounting the housing on the fixing device; and
      S222: rotating the fixing device by the rotatable table to the contact assembly station; and
S300: pressing the contact into the housing by the pressing mechanism.

In the above various exemplary embodiments of the present disclosure, the assembly system may automatically complete the task of assembling the contact into the housing. Thereby, it may improve the efficiency of assembling the contact into the housing, prevent the contact from damage during assembling it, and improve the quality of the assembly product.

### BRIEF DESCRIPTION OF THE DRAWINGS

The above and other features of the present disclosure will become more apparent by describing in detail exemplary embodiments thereof with reference to the accompanying drawings, in which:
Fig.1 is an illustrative perspective view of an assembly system according to an exemplary embodiment of the present disclosure;
Fig.2 is an illustrative perspective view of a contact supply mechanism, a contact positioning mechanism and a contactless sensor of the assembly system of Fig.1;
Fig.3 is an illustrative perspective view of the contact positioning mechanism and the contactless sensor of the assembly system of Fig.1; and
Fig.4 is an illustrative perspective view of a pressing mechanism of the assembly system of Fig.1.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to the present invention, there is provided an assembly system, comprising: a fixing device configured to fix a housing; and a pressing mechanism adapted to assemble a contact into the housing. The pressing mechanism comprises: a fixing block formed with a contact guiding slot adapted to receive the contact therein; and a movable block movably mounted on the fixing block and adapted to press the contact downward, the movable block is moved downward to press the contact received in the contact guiding slot into a contact installation slot of the housing in a condition where the contact guiding slot of the fixing block is aligned to the contact installation slot of the housing.

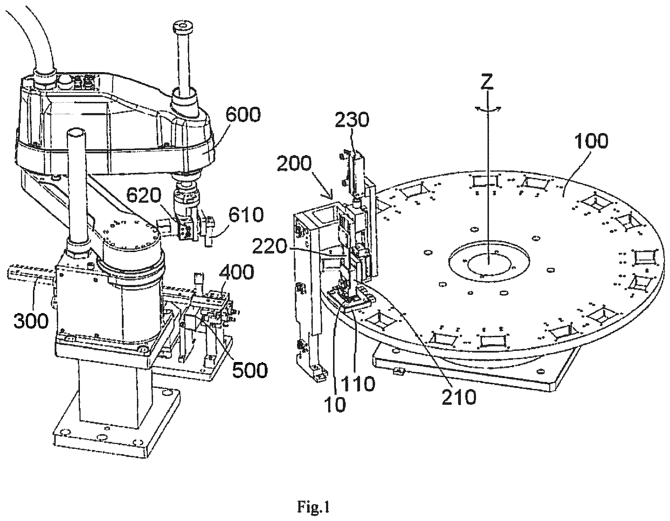

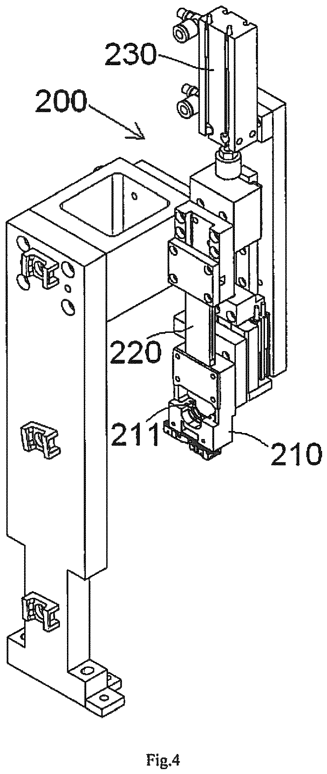

Fig.1 is an illustrative perspective view of an assembly system according to an exemplary embodiment of the present disclosure; Fig.4 is an illustrative perspective view of a pressing mechanism of the assembly system of Fig.1.

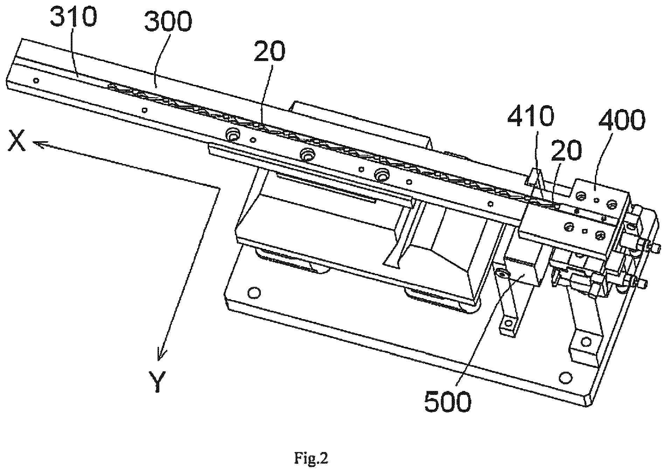

As shown in Figs.1 and 4, in an embodiment, the assembly system mainly comprises a fixing device 110 and a pressing mechanism 200. The fixing device 110 is configured to fix a housing 10, for example, an insulation housing of a connector. The pressing mechanism 200 is adapted to assemble a contact 20 (see Figs.2-3) into the housing 10.

As shown in Figs.1 and 4, in an embodiment, the pressing mechanism 200 mainly comprises a fixing block 210 and a movable block 220. The fixing block 210 is formed with a contact guiding slot 211 adapted to receive the contact 20 therein. The movable block 220 is movably mounted on the fixing block 210 and adapted to press the contact 20 downward.

As shown in Figs.1 and 4, in an embodiment, the movable block 220 is driven to move downward to press the contact 20 received in the contact guiding slot 211 into a contact installation slot of the housing 10 in a condition where the contact guiding slot 211 of the fixing block 210 is aligned to the contact installation slot of the housing 10.

As shown in Figs. 1 and 4, in an embodiment, the assembly system further comprises a rotatable table 100 configured to be rotatable about a vertical axis Z. The fixing device 110 is mounted on the rotatable table 100, and the rotatable table 100 is adapted to rotate the fixing device 110 to a contact assembly station where the contact installation slot (not shown) of the housing 10 fixed on the fixing device 110 is aligned to the contact guiding slot 211 of the fixing block 210 on the pressing mechanism 200. In this way, when movable block 220 is moved downward, the contact 20 received in the contact guiding slot 211 may be pressed into the contact installation slot of the housing 10.

As shown in Figs.1 and 4, in an embodiment, a plurality of fixing devices 110 are mounted on the rotatable table 100 around the periphery of rotatable table 100 and separated from each other. The rotatable table 100 is adapted to rotate the plurality of fixing devices 110 to the contact assembly station one by one.

As shown in Figs.1 and 4, in an embodiment, the pressing mechanism 200 further comprises a driving device 230 configured to drive the movable block 220 to move downward. The driving device 230 may comprise a motor, an air cylinder or a hydraulic cylinder.

As shown in Figs.1 and 4, in an embodiment, a plurality of contact guiding slots 211 are formed in the fixing block 210, each contact installation slot being constructed to hold one contact therein, and a plurality of contact installation slots are formed in the housing 10. The pressing mechanism 200 is adapted to press the plurality of contacts 20 received in the plurality of contact guiding slots 211, respectively, into the plurality of contact installation slots at one time.

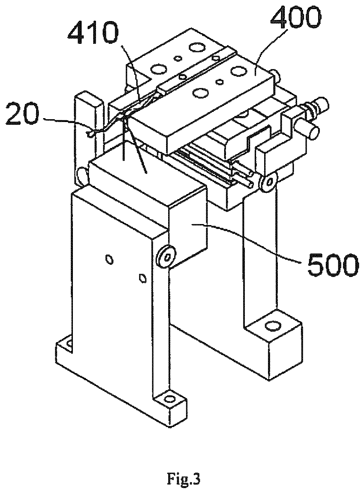

Fig.2 is an illustrative perspective view of a contact supply mechanism, a contact positioning mechanism and a contactless sensor of the assembly system of Fig.1; Fig.3 is an illustrative perspective view of the contact positioning mechanism and the contactless sensor of the assembly system of Fig.1.

As shown in Figs. 1-4, in an embodiment, the assembly system further comprises a robot 600 adapted to grip the contact 20 and insert the gripped contact 20 into the contact guiding slot 211 of the fixing block 210.

As shown in Figs. 1-4, in an embodiment, the assembly system further comprises a contact supply mechanism 300 configured to supply the contact 20 to be assembled.

As shown in Figs. 1-4, in an embodiment, the assembly system further comprises a contact positioning mechanism 400 formed with a contact positioning slot 410 in which the contact 20 is adapted to be positioned.

As shown in Figs. 1-4, in an embodiment, the contact supply mechanism 300 comprises a linear vibration guide 310 extending in a first horizontal direction X, and the contacts 20 to be assembled are adapted to be loaded in the linear vibration guide 310. The contact positioning slot 410 of the contact positioning mechanism 400 is located at one end of the linear vibration guide 310 and aligned to the linear vibration guide 310. The linear vibration guide 310 is adapted to drive the contacts 20 by vibration, so as to move the contacts 20 toward the contact positioning slot 410 of the contact positioning mechanism 400.

As shown in Figs. 1-4, in an embodiment, the contact positioning mechanism 400 is configured to be movable in a second horizontal direction Y perpendicular to the first horizontal direction X. The contact positioning mechanism 400 is moved in the second horizontal direction Y and separated from the linear vibration guide 310 after the contact 20 is moved from the linear vibration guide 310 into the contact positioning slot 410.

As shown in Figs. 1-4, in an embodiment, the assembly system further comprises a contactless sensor 500 configured to detect whether the contact 20 in the contact positioning mechanism 400 is qualified. If the contact 20 is not qualified, then the robot 600 will grip and discard the unqualified contact 20.

As shown in Figs. 1-4, in an embodiment, the contactless sensor 500 may comprise a distance sensor, a visual sensor or an infrared sensor.

In an exemplary embodiment of the present disclosure, the contactless sensor 500 may be fixed to the contact positioning mechanism 400 and moved together with the contact positioning mechanism 400 in the second horizontal direction Y.

As shown in Figs.2-3, in an embodiment, the contact positioning slot 410 of the contact positioning mechanism 400 is adapted to position the contact 20 in a horizontal posture.

As shown in Figs. 1-4, in an embodiment, the robot 600 comprises a manipulator 610 adapted to grip the contact 20 positioned in the horizontal posture from the contact positioning slot 410.

As shown in Figs. 1-4, in an embodiment, the robot 600 comprises a rotation mechanism 620 adapted to rotate the manipulator 610, so as to rotate the contact 20 from the horizontal posture to a vertical posture.

As shown in Figs. 1-4, in an embodiment, the robot 600 is adapted to insert the gripped contact 20 in the vertical posture into the contact guiding slot 211 of the pressing mechanism 200.

In another non-claimed example of the present disclosure, there is also provided a method of assembling a contact 20 into a housing 10, comprising steps of:
S100: providing the assembly system as mentioned in the above embodiment;
S200: synchronously performing the following steps S210 and S220, wherein
   the step S210 comprises steps of:
      S211: supplying the contact 20 to the contact positioning mechanism 400 by the contact supply mechanism 300;
      S212: moving the contact positioning mechanism 400 to separate it from the contact supply mechanism 300;
      S213: detecting whether the contact 20 in the contact positioning mechanism 400 is qualified by the contactless sensor 500;
      S214: gripping the contact 20 in the horizontal posture from the contact positioning mechanism 400 by the robot 600;
      S215: rotating the gripped contact 20 from the horizontal posture to the vertical posture by the robot 600; and
      S216: inserting the gripped contact 20 in the vertical posture into the contact guiding slot 211 of the pressing mechanism 200 by the robot 600, and
   the step S220 comprises steps of:
      S221: mounting the housing 10 on the fixing device 110; and
      S222: rotating the fixing device 110 by the rotatable table 100 to the contact assembly station; and
S300: pressing the contact 20 into the housing 10 by the pressing mechanism 200.

As used herein, an element recited in the singular and proceeded with the word "a" or "an" should be understood as not excluding plural of said elements or steps, unless such exclusion is explicitly stated. Furthermore, references to "one embodiment" of the present disclosure are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. An assembly system for inserting a contact (20) in a housing (10), comprising:
a fixing device (110) configured to fix the housing (10); and
a pressing mechanism (200) adapted to assemble the contact (20) into the housing (10),
wherein the pressing mechanism (200) comprises:
a fixing block (210) formed with a contact guiding slot (211) adapted to receive the contact (20) therein; and
a movable block (220) adapted to press the contact (20) downward,
wherein the movable block (220) is moved downward to press the contact (20) received in the contact guiding slot (211) into a contact installation slot of the housing (10) in a condition where the contact guiding slot (211) of the fixing block (210) is aligned to the contact installation slot of the housing (10),
**characterized in that** the movable block (220) is movably mounted on the fixing block (210).

2. The assembly system according to claim 1, further comprising:
a rotatable table (100) configured to be rotated about a vertical axis (Z),
wherein the fixing device (110) is mounted on the rotatable table (100), and the rotatable table (100) is adapted to rotate the fixing device (110) to a contact assembly station where the contact installation slot of the housing (10) fixed on the fixing device (110) is aligned to the contact guiding slot (211) of the fixing block (210) on the pressing mechanism (200).

3. The assembly system according to claim 2, wherein a plurality of fixing devices (110) are mounted on the rotatable table (100) around the periphery of rotatable table (100) and separated from each other, and
wherein the rotatable table (100) is adapted to rotate the plurality of fixing devices (110) to the contact assembly station one by one.

4. The assembly system according to any one of claims 1-3, wherein the pressing mechanism (200) further comprises a driving device (230) configured to drive the movable block (220) to move downward.

5. The assembly system according to claim 4, wherein the driving device (230) comprises a motor, an air cylinder or a hydraulic cylinder.

6. The assembly system according to any one of claims 1-5, wherein a plurality of contact guiding slots (211) are formed in the fixing block (210), and a plurality of contact installation slots are formed in the housing (10), and
wherein the pressing mechanism (200) is adapted to press a plurality of contacts (20) received in the plurality of contact guiding slots (211), respectively, into the plurality of contact installation slots at one time.

7. The assembly system according to any one of claims 2-6, further comprising:
a robot (600) adapted to grip the contact (20) and insert the gripped contact (20) into the contact guiding slot (211) of the fixing block (210).

8. The assembly system according to claim 7, further comprising:
a contact supply mechanism (300) configured to supply the contact (20) to be assembled.

9. The assembly system according to claim 8, further comprising:
a contact positioning mechanism (400) formed with a contact positioning slot (410) in which the contact (20) is adapted to be positioned.

10. The assembly system according to claim 9, wherein the contact supply mechanism (300) comprises a linear vibration guide (310) extending in a first horizontal direction (X), the contacts (20) to be assembled being loaded in the linear vibration guide (310);
wherein the contact positioning slot (410) of the contact positioning mechanism (400) is located at one end of the linear vibration guide (310) and aligned to the linear vibration guide (310); and
wherein the linear vibration guide (310) is adapted to drive the contacts (20) by vibration, so as to move the contacts (20) toward the contact positioning slot (410) of the contact positioning mechanism (400).

11. The assembly system according to claim 10, wherein the contact positioning mechanism (400) is configured to be movable in a second horizontal direction (Y) perpendicular to the first horizontal direction (X); and
wherein the contact positioning mechanism (400) is moved in the second horizontal direction (Y) and separated from the linear vibration guide (310) after the contact (20) is moved from the linear vibration guide (310) into the contact positioning slot (410).

12. The assembly system according to claim 11, further comprising:
a contactless sensor (500) configured to detect whether the contact (20) in the contact positioning mechanism (400) is qualified.

13. The assembly system according to claim 12, wherein the contactless sensor (500) comprises a distance sensor, a visual sensor or an infrared sensor.

14. The assembly system according to claim 12, wherein the contactless sensor (500) is fixed to the contact positioning mechanism (400) and moved together with the contact positioning mechanism (400) in the second horizontal direction (Y).

15. The assembly system according to claim 11, wherein the contact positioning slot (410) of the contact positioning mechanism (400) is adapted to position the contact (20) in a horizontal posture.

16. The assembly system according to claim 15, wherein the robot (600) comprises a manipulator (610) adapted to grip the contact (20) positioned in the horizontal posture from the contact positioning mechanism (400).

17. The assembly system according to claim 16, wherein the robot (600) further comprises a rotation mechanism (620) adapted to rotate the manipulator (610), so as to rotate the contact (20) from the horizontal posture to a vertical posture.

18. The assembly system according to claim 17, wherein the robot (600) is adapted to insert the gripped contact (20) in the vertical posture into the contact guiding slot (211) of the pressing mechanism (200).

## Patentansprüche

1. Montagesystem zum Einführen eines Kontaktes (20) in ein Gehäuse (10), das umfasst:
eine Fixiervorrichtung (110), die zum Fixieren des Gehäuses (10) ausgeführt ist; sowie
einen Drückmechanismus (200), der zum Einsetzen des Kontaktes (20) in das Gehäuse (10) eingerichtet ist,
wobei der Drückmechanismus (200) umfasst:
einen Fixierblock (210), der mit einem Kontakt-Führungsschlitz (211) versehen ist, der zum Aufnehmen des Kontaktes (20) darin eingerichtet ist; und
einen beweglichen Block (220), der zum Pressen des Kontaktes (20) nach unten eingerichtet ist,
wobei der bewegliche Block (220) nach unten bewegt wird, um den in dem Kontakt-Führungsschlitz (211) aufgenommenen Kontakt (20) in einem Zustand in einen Kontakt-Installationsschlitz des Gehäuses (10) hinein zu drücken, in dem der Kontakt-Führungsschlitz (211) des Fixierblocks (210) auf den Kontakt-Installationsschlitz des Gehäuses (10) ausgerichtet ist,
**dadurch gekennzeichnet, dass** der bewegliche Block (220) beweglich an dem Fixierblock (210) angebracht ist.

2. Montagesystem nach Anspruch 1, das des Weiteren umfasst:
einen drehbaren Tisch (100), der so ausgeführt ist, dass er um eine vertikale Achse (Z) herum gedreht wird,
wobei die Fixiervorrichtung (110) an dem drehbaren Tisch (100) angebracht ist und der drehbare Tisch (100) so eingerichtet ist, dass er die Fixiervorrichtung (110) zu einer Kontakt-Montagestation dreht, wo der Kontakt-Installationsschlitz des an der Fixiervorrichtung (110) fixierten Gehäuses (10) auf den Kontakt-Führungsschlitz (211) des Fixierblocks (210) an dem Drückmechanismus (200) ausgerichtet wird.

3. Montagesystem nach Anspruch 2, wobei eine Vielzahl von Fixiervorrichtungen (110) um den Umfang des drehbaren Tisches (100) herum und voneinander getrennt an dem drehbaren Tisch (100) angebracht sind, und
der Drehtisch (100) so eingerichtet ist, dass er die Vielzahl von Fixiervorrichtungen (110) nacheinander zu der Kontakt-Montagestation dreht.

4. Montagesystem nach einem der Ansprüche 1 - 3, wobei der Drückmechanismus (200) des Weiteren eine Antriebsvorrichtung (230) umfasst, die so ausgeführt ist, dass sie den beweglichen Block (220) nach unten in Bewegung versetzt.

5. Montagesystem nach Anspruch 4, wobei die Antriebsvorrichtung (230) einen Motor, einen Luftzylinder oder einen Hydraulikzylinder umfasst.

6. Montagesystem nach einem der Ansprüche 1 - 5, wobei eine Vielzahl von Kontakt-Führungsschlitzen (211) in dem Fixierblock (210) ausgebildet sind und eine Vielzahl von Kontakt-Installationsschlitzen in dem Gehäuse (10) ausgebildet sind, und
der Drückmechanismus (200) so eingerichtet ist, dass er eine Vielzahl von Kontakten (20), die jeweils in der Vielzahl von Kontakt-Führungsschlitzen (211) aufgenommen sind, gleichzeitig in die Vielzahl von Kontakt-Installationsschlitzen hinein drückt.

7. Montagesystem nach einem der Ansprüche 2 - 6, das des Weiteren umfasst:
einen Roboter (600), der so eingerichtet ist, dass er den Kontakt (20) ergreift und den ergriffenen Kontakt (20) in den Kontakt-Führungsschlitz (211) des Fixierblocks (210) einführt.

8. Montagesystem nach Anspruch 7, das des Weiteren umfasst:
einen Kontakt-Zuführmechanismus (300), der so ausgeführt ist, dass er den zu montierenden Kontakt (20) zuführt.

9. Montagesystem nach Anspruch 8, das des Weiteren umfasst:
einen Kontakt-Positioniermechanismus (400), der mit einem Kontakt-Positionierschlitz (410) versehen ist, in dem der Kontakt (20) positioniert wird.

10. Montagesystem nach Anspruch 9, wobei der Kontakt-Zuführmechanismus (300) eine lineare Vibrations-Führungseinrichtung (310) umfasst, die sich in einer ersten horizontalen Richtung (X) erstreckt, wobei die zu montierenden Kontakte (20) in die lineare Vibrations-Führungseinrichtung (310) geladen werden;
sich der Kontakt-Positionierschlitz (410) des Kontakt-Positioniermechanismus (400) an einem Ende der linearen Vibrations-Führungseinrichtung (310) befindet und auf die lineare Vibrations-Führungseinrichtung (310) ausgerichtet ist; und
die lineare Vibrations-Führungseinrichtung (310) so eingerichtet ist, dass sie die Kontakte (20) durch Vibration antreibt und die Kontakte (20) so in Richtung des Kontakt-Positionierschlitzes (410) des Kontakt-Positioniermechanismus (400) bewegt.

11. Montagesystem nach Anspruch 10, wobei der Kontakt-Positioniermechanismus (400) so ausgeführt ist, dass er in einer zweiten horizontalen Richtung (Y) senkrecht zu der ersten horizontalen Richtung (X) bewegt werden kann; und
der Kontakt-Positioniermechanismus (400) in der zweiten horizontalen Richtung (Y) bewegt und von der linearen Vibrations-Führungseinrichtung (310) getrennt wird, nachdem der Kontakt (20) von der linearen Vibrations-Führungseinrichtung (310) in den Kontakt-Positionierschlitz (410) hinein bewegt worden ist.

12. Montagesystem nach Anspruch 11, das des Weiteren umfasst:
einen kontaktlosen Sensor (500), der so ausgeführt ist, dass er erfasst, ob der Kontakt (20) in dem Kontakt-Positioniermechanismus (400) geeignet ist.

13. Montagesystem nach Anspruch 12, wobei der kontaktlose Sensor (500) einen Abstandssensor, einen optischen Sensor oder einen Infrarotsensor umfasst.

14. Montagesystem nach Anspruch 12, wobei der kontaktlose Sensor (500) an dem Kontakt-Positioniermechanismus (400) befestigt ist und zusammen mit dem Kontakt-Positioniermechanismus (400) in der zweiten horizontalen Richtung (Y) bewegt wird.

15. Montagesystem nach Anspruch 11, wobei der Kontakt-Positionierschlitz (410) des Kontakt-Positioniermechanismus (400) so eingerichtet ist, dass er den Kontakt (20) in einer horizontalen Lage positioniert.

16. Montagesystem nach Anspruch 15, wobei der Roboter (600) einen Manipulator (610) umfasst, der so eingerichtet ist, dass er den von dem Kontakt-Positioniermechanismus (400) in der horizontalen Lage positionierten Kontakt (20) ergreift.

17. Montagesystem nach Anspruch 16, wobei der Roboter (600) des Weiteren einen Drehmechanismus (620) umfasst, der so eingerichtet ist, dass er den Manipulator (610) dreht, um den Kontakt (20) aus der horizontalen Lage in eine vertikale Lage zu drehen.

18. Montagesystem nach Anspruch 17, wobei der Roboter (600) so eingerichtet ist, dass er den ergriffenen Kontakt (20) in der vertikalen Lage in den Kontakt-Führungsschlitz (211) des Drückmechanismus (200) einführt.

## Revendications

1. Système d'assemblage pour insérer un contact (20) dans un boîtier (10), comprenant :
un dispositif de fixation (110) configuré pour fixer le boîtier (10) ; et
un mécanisme de pression (200) adapté pour assembler le contact (20) dans le boîtier (10),
dans lequel le mécanisme de pression (200) comprend :
un bloc de fixation (210) formé avec une fente de guidage de contact (211) adaptée pour y recevoir le contact (20) ; et
un bloc mobile (220) adapté pour presser le contact (20) vers le bas,
dans lequel le bloc mobile (220) est déplacé vers le bas pour presser le contact (20) reçu dans la fente de guidage de contact (211) dans une fente d'installation de contact du boîtier (10) dans un état où la fente de guidage de contact (211) du bloc de fixation (210) est alignée sur la fente d'installation de contact du boîtier (10),
**caractérisé en ce que** le bloc mobile (220) est monté de façon mobile sur le bloc de fixation (210).

2. Système d'assemblage selon la revendication 1, comprenant en outre :
une table rotative (100) configurée pour être tournée autour d'un axe vertical (Z),
dans lequel le dispositif de fixation (110) est monté sur la table rotative (100), et la table rotative (100) est adaptée pour faire tourner le dispositif de fixation (110) vers un poste d'assemblage de contact où la fente d'installation de contact du boîtier (10) fixé sur le dispositif de fixation (110) est alignée sur la fente de guidage de contact (211) du bloc de fixation (210) sur le mécanisme de pression (200) .

3. Système d'assemblage selon la revendication 2, dans lequel une pluralité de dispositifs de fixation (110) sont montés sur la table rotative (100) autour de la périphérie de la table rotative (100) et séparés les uns des autres, et
dans lequel la table rotative (100) est adaptée pour faire tourner la pluralité de dispositifs de fixation (110) vers le poste d'assemblage de contact un par un.

4. Système d'assemblage selon l'une quelconque des revendications 1 à 3, dans lequel le mécanisme de pression (200) comprend en outre un dispositif d'entraînement (230) configuré pour entraîner le bloc mobile (220) pour se déplacer vers le bas.

5. Système d'assemblage selon la revendication 4, dans lequel le dispositif d'entraînement (230) comprend un moteur, un vérin pneumatique ou un vérin hydraulique.

6. Système d'assemblage selon l'une quelconque des revendications 1 à 5, dans lequel une pluralité de fentes de guidage de contact (211) sont formées dans le bloc de fixation (210), et une pluralité de fentes d'installation de contact sont formées dans le boîtier (10), et
dans lequel le mécanisme de pression (200) est adapté pour presser une pluralité de contacts (20) reçus dans la pluralité de fentes de guidage de contact (211), respectivement, dans la pluralité de fentes d'installation de contact en une seule fois.

7. Système d'assemblage selon l'une quelconque des revendications 2 à 6, comprenant en outre :
un robot (600) adapté pour saisir le contact (20) et insérer le contact saisi (20) dans la fente de guidage de contact (211) du bloc de fixation (210).

8. Système d'assemblage selon la revendication 7, comprenant en outre :
un mécanisme d'alimentation en contact (300) configuré pour fournir le contact (20) à assembler.

9. Système d'assemblage selon la revendication 8, comprenant en outre :
un mécanisme de positionnement de contact (400) formé avec une fente de positionnement de contact (410) dans laquelle le contact (20) est adapté pour être positionné.

10. Système d'assemblage selon la revendication 9, dans lequel le mécanisme d'alimentation en contact (300) comprend un guide de vibration linéaire (310) s'étendant dans une première direction horizontale (X), les contacts (20) à assembler étant chargés dans le guide de vibration linéaire (310) ;
dans lequel la fente de positionnement de contact (410) du mécanisme de positionnement de contact (400) est située au niveau d'une extrémité du guide de vibration linéaire (310) et alignée sur le guide de vibration linéaire (310) ; et
dans lequel le guide de vibration linéaire (310) est adapté pour entraîner les contacts (20) par vibration, de manière à déplacer les contacts (20) vers la fente de positionnement de contact (410) du mécanisme de positionnement de contact (400).

11. Système d'assemblage selon la revendication 10, dans lequel le mécanisme de positionnement de contact (400) est configuré pour être mobile dans une deuxième direction horizontale (Y) perpendiculaire à la première direction horizontale (X) ; et
dans lequel le mécanisme de positionnement de contact (400) est déplacé dans la deuxième direction horizontale (Y) et séparé du guide de vibration linéaire (310) après que le contact (20) est déplacé du guide de vibration linéaire (310) dans la fente de positionnement de contact (410).

12. Système d'assemblage selon la revendication 11, comprenant en outre :
un capteur sans contact (500) configuré pour détecter si le contact (20) dans le mécanisme de positionnement de contact (400) est qualifié.

13. Système d'assemblage selon la revendication 12, dans lequel le capteur sans contact (500) comprend un capteur de distance, un capteur visuel ou un capteur infrarouge.

14. Système d'assemblage selon la revendication 12, dans lequel le capteur sans contact (500) est fixé au mécanisme de positionnement de contact (400) et déplacé conjointement avec le mécanisme de positionnement de contact (400) dans la deuxième direction horizontale (Y).

15. Système d'assemblage selon la revendication 11, dans lequel la fente de positionnement de contact (410) du mécanisme de positionnement de contact (400) est adaptée pour positionner le contact (20) dans une posture horizontale.

16. Système d'assemblage selon la revendication 15, dans lequel le robot (600) comprend un manipulateur (610) adapté pour saisir le contact (20) positionné dans la posture horizontale à partir du mécanisme de positionnement de contact (400).

17. Système d'assemblage selon la revendication 16, dans lequel le robot (600) comprend en outre un mécanisme de rotation (620) adapté pour faire tourner le manipulateur (610), de manière à faire tourner le contact (20) de la posture horizontale à une posture verticale.

18. Système d'assemblage selon la revendication 17, dans lequel le robot (600) est adapté pour insérer le contact saisi (20), qui est dans la posture verticale, dans la fente de guidage de contact (211) du mécanisme de pression (200).
